# EUROPÄISCHE PATENTSCHRIFT

(11) **EP 1 119 913 B1**
(45) Veröffentlichungstag und Bekanntmachung des Hinweises auf die Patenterteilung: **27.02.2008**
(21) Anmeldenummer: 99957860.2
(22) Anmeldetag: 01.10.1999
(51) Int. Cl.: H03K 17/96

(54) **BETÄTIGUNGSELEMENT FÜR EINEN ELEKTRISCHEN SCHALTER**
ACTUATING ELEMENT FOR AN ELECTRIC SWITCH
ELEMENT D'ACTIONNEMENT POUR UN COMMUTATEUR ELECTRIQUE

(30) Priorität: 09.10.1998 DE 19846615
(43) Veröffentlichungstag der Anmeldung: 01.08.2001
(73) Patentinhaber: Delphi Technologies Inc., Troy, MI 48007 (US)
(72) Erfinder: SCHWEIGERT, Markus, D-55444 Seibersbach (DE); SCHNELL, Klaus, D-55435 Gau-Algesheim (DE)
(74) Vertreter: Becker, Bernd
(86) Internationale Anmeldenummer: PCT/DE1999/003215
(87) Internationale Veröffentlichungsnummer: WO 2000/022732

(56) Entgegenhaltungen:
- EP-A- 0 446 642
- EP-A- 0 590 550
- EP-A- 0 805 247
- DE-A- 19 537 168

## Beschreibung

Die Erfindung bezieht sich auf ein mechanisches Betätigungselement für einen elektrischen Schalter, insbesondere Kraftfahrzeugschalter, mit einem integrierten Sensor.

Betätigungselemente für elektrische Schalter sind in den verschiedensten Ausführungsformen bekannt und entsprechend ihren Schaltfunktionen gestaltet. Zur Auswahl von zwei Schaltfunktionen kommen in der Regel als Betätigungselemente Druck- oder Wipptasten zum Einsatz. Bei der Regelung einer Schaltfunktion oder bei der Auswahl einer von mehreren Schaltfunktionen werden als Betätigungselemente meist unterschiedlich ausgeführte Drehknöpfe eingesetzt. Die Schaltfunktionen, die der Kraftfahrzeugführer auswählen kann, sind häufig auf einer Blende des Schalters als Symbole dargestellt und oftmals zur Wahrnehmung im Dunkeln hinterleuchtet. Allerdings erhält der Kraftfahrzeugführer keine visuelle Rückmeldung über eventuelle Gefahren, die durch die Auswahl einer entsprechenden Schaltfunktion entstehen können, z.B. bei der elektrischen Zu- bzw. Abschaltung eines Allradantriebes des Kraftfahrzeugs.

Zunehmend erfüllen elektrische Schalter in Kraftfahrzeugen sehr komplexe Aufgaben, die relativ langandauernde Rechenvorgänge in einer zentralen Rechnereinheit des Kraftfahrzeuges auslösen, wobei der Kraftfahrzeugführer diese Zeitspanne wahrnimmt. Eine solche Aufgabe ist beispielsweise die Aufbereitung von Daten über die Berechtigung des Kraftfahrzeugführers, das Kraftfahrzeug zu starten und die anschließende Deaktivierung der elektronischen Wegfahrsperre des Kraftfahrzeuges.

Aus der EP 0 805 247 A1 ist eine Identifikationseinrichtung bekannt, die einen Sensor mit einem Betätigungselement umfasst, auf das ein Finger eines Benutzers auflegbar ist. Damit die Identifikationseinrichtung nur dann in Betrieb ist, wenn ein Identifikationsvorgang gestartet werden soll, wird sie durch einen Schalter erst dann eingeschaltet, wenn der Finger das Betätigungselement berührt.

Darüberhinaus offenbart die EP 0 446 642 A1 eine Vorrichtung zum Schalten elektronischer Einrichtungen. Die Vorrichtung umfasst eine Reflexionslichtschranke, die unter einer transparenten Platte angeordnet ist.

Es ist Aufgabe der Erfindung, ein Betätigungselement der eingangs genannten Art zu schaffen, das den Ablauf einer Schaltfunktion des Schalters ohne merkbare Zeitverzögerung für den Kraftfahrzeugführer durchführt.

Erfindungsgemäß wird die Aufgabe dadurch gelöst, daß der Sensor bei der Annäherung einer Hand an das Betätigungselement mindestens eine der Schaltfunktion des Schalters vorgeordnete Schaltfunktion auslöst, die beendet ist, bevor der eigentliche, durch die entsprechende Beaufschlagung des Betätigungselementes definierte Schaltvorgang beginnt.

Durch diese Maßnahme registriert bereits beim Hinlagen zu dem Betätigungselement der integrierte Sensor die Annäherung der Hand des Kraftfahrzeugführers an den Schalter, wodurch die entsprechende Schaltfunktion, die der Schaltfunktion des Schalters vorgeordnet ist, ausgeführt wird. Die Zeitspanne, in der der Kraftfahrzeugführer das Betätigungselement greift und bewegt, wird zur Ausführung der vorgeordneten Schaltfunktion ausgenutzt, so daß diese beendet ist, bis der eigentliche Schaltvorgang, der durch die entsprechende Bewegung des Betätigungselementes definiert ist, beginnt. Selbstverständlich können auch mehrere Schaltfunktionen einer oder mehreren Schaltfunktionen des Schalters vorgelagert sein.

Nach einer vorteilhaften Ausgestaltung der Erfindung ist der Sensor als Reflexionslichtschranke, als Fingerabdruckerkennungssensor, als Infrarotsensor oder dgl. ausgebildet. Der Sensor wird nach den Erfordernissen des dem Betätigungselement zugeordneten Schalters ausgewählt. Sollen die Schaltfunktionen des Schalters beispielsweise nur einem berechtigten Kraftfahrzeugführer zugänglich sein, so überprüft der Fingerabdruckerkennungssensor die Berechtigung desjenigen, der an das Betätigungselement greift. Die Reflexionslichtschranke löst mindestens einen der Schaltfunktion des Schalters vorgeordneten Schaltvorgang bereits dann aus, wenn der Kraftfahrzeugführer in den entsprechenden Wirkungsbereich hineinlangt. Der Infrarotsensor reagiert bei der Berührung des Betätigungselementes durch den Kraftfahrzeugführer auf entsprechende Weise.

Zweckmäßigerweise umfaßt die Reflexionslichtschranke eine eine Lichtstrahlung emittierende Leuchtdiode als Sender und einen Fototransistor als Empfänger, wobei das Betätigungselement mindestens in den Bereichen, in denen die Leuchtdiode und der Fototransistor angeordnet sind, transparent ausgebildet ist. Die zumindest bereichsweise Transparenz des Betätigungelementes ist selbstverständlich deshalb notwendig, damit die von der Leuchtdiode emittierte Lichtstrahlung in einen Bereich außerhalb des Betätigungselementes und die von dem Kraftfahrzeugführer reflektierte Lichtstrahlung in den Wirkungsbereich des Fotosensors gelangen kann.

Vorzugsweise ist die emittierte Lichtstrahlung ein Infrarotlicht. Zur Abschirmung von einfallendem Tageslicht, auf das der Fotosensor ansprechen könnte, ist der Empfänger der Lichtstrahlung von einem Tageslichtfilter umgeben.

Eine spezielle Beleuchtung des Schalters, die bei einer Annäherung aufleuchtet, erlaubt eine bessere Identifikation desselben. Daher ist zweckmäßigerweise eine von dem Sensor angesteuerte Suchbeleuchtung in das Betätigungselement integriert.

Bevorzugt ist ferner eine von dem Sensor geschaltete Funktionsbeleuchtung in das Betätigungselement integriert. Bei einer weiteren Ausgestaltung ändert sich die Lichtfarbe der Funktionsbeleuchtung in Abhängigkeit von der Schaltfunktion des Schalters in eine "Warnfarbe". Der Kraftfahrzeugführer wird sonach durch die Farbänderung der Funktionsbeleuchtung vor der Aktivierung sicherheitsrelevanter Schaltfunktionen gewarnt, und zwar bevor das Betätigungselement mechanisch verstellt wird.

Zweckmäßigerweise umfaßt die Suchbeleuchtung bzw. die Funktionsbeleuchtung mindestens eine Leuchtdiode, einen Lichtleiter oder dgl.. Diese Bauteile sind kostengünstig und vielseitig verwendbar. Ferner lassen sich mit üblichen Leuchtdioden bzw. Lichtleitern diverse Lichtfarben darstellen.

Nach einer vorteilhaften Weiterbildung der Erfindung ist der Sensor mit einer zentralen, komplexe Schaltfunktionen aufbereitenden Rechnereinheit des Kraftfahrzeuges gekoppelt. Bevorvorzugt ist nach einer Beaufschlagung des in das Betätigungseelement integrierten Fingerabdruckerkennungssensors durch einen berechtigten Kraftfahrzeugführer die elektronische Wegfahrsperre durch die dem Fingerabdruckerkennungssensor zugeordnete Schaltfunktion deaktiviert. Hierbei vergleicht die Rechnereinheit gespeicherte Fingerabdrücke mit demjenigen, den der Sensor aufgrund seiner Beaufschlagung registriert, und deaktiviert die elektronische Wegfahrsperre des Kraftfahrzeuges, falls der vom Sensor registrierte Fingerabdruck mit einem von der Rechnereinheit gespeicherten Fingerabdruck übereinstimmt. Dieser Vergleichsvorgang der Fingerabdrücke erfolgt in einem Zeitraum, den der Kraftfahrzeugführer zur mechanischen Auswahl der Schaltfunktion des Schalters durch die Beaufschlagung des Betätigungselementes benötigt. Der Vergleichsvorgang wird also von dem Kraftfahrzeugführer nicht bemerkt.

Weiterhin ist zweckmäßigerweise nach einer Beaufschlagung des in das Betätigungselement integrierten Fingerabdruckerkennungssensors durch einen berechtigten Kraftfahrzeugführer die verriegelte Lenksäule über die dem Fingerabdruckerkennungssensor zugeordnete Schaltfunktion entriegelt. Die von der Rechnereinheit gesteuerte Entriegelung der Lenksäule kann mittels eines magnetisch oder mechanisch betätigten Verriegelungsbolzens bewirkt werden, wobei die Berechtigung des Kraftfahrzeugführers anhand dessen Fingerabdrucks festgestellt wird.

Es versteht sich, daß die vorstehend genannten und nachstehend noch zu erläuternden Merkmale nicht nur in der jeweils angegebenen Kombination, sondern auch in anderen Kombinationen verwendbar sind, ohne den Rahmen der vorliegenden Erfindung zu verlassen.

Die Erfindung wird im folgenden anhand eines Ausführungsbeispieles unter Bezugnahme auf die zugehörigen Zeichnungen näher erläutert. Es zeigen:
- Fig.1: eine Darstellung eines erfindungsgemäßen Betätigungselementes eines elektrischen Schalters,
- Fig.2: eine Darstellung des Betätigungselementes nach Fig. 1 als Blockschaltbild und
- Fig.3: eine Darstellung eines Schaltplanes zu dem Betätigungselement nach Fig. 1.

Das als Drehknopf 1 ausgebildete Betätigungselement 2 umfaßt einen umfangsseitigen Wulst 3 sowie einen durch den Wulst 3 begrenzten Steg 4, der gegenüberliegende Angriffsflächen 5 für einen Daumen 6 und einen Finger 7 eines Kraftfahrzeugführers aufweist. In die Rückseite des Drehknopfes 1 ist eine konzentrische Aufnahme 8 für die Lagerung des Drehknopfes 1 in einem Gehäuse 9 eines elektrischen Schalters 10 eingelassen.

Innerhalb des Steges 4 des Drehknopfes 1 ist in einem transparenten Bereich 11 eine Reflexionslichtschranke 12 angeordnet, die eine eine infrarote Lichtstrahlung 13 emittierende Leuchtdiode 14 und einen Fototransistor 15 sowie dazugehörige Elektronik 16 umfaßt. Die Reflexionslichtschranke 12 stellt einen Sensor in einer besonderen Ausführung dar.

Der Wulst 3 des Drehknopfes 1 ist transparent ausgeführt und nimmt einen umlaufenden Lichtleiter 17 auf, dessen Lichtfarbe veränderbar ist.

Die Anschlußkontakte 18 der Reflexionslichtschranke 12 und die Anschlußkontakte 19 des Lichtleiters 17 können zur Verbindung mit dem Bordnetz bzw. einer zentralen Rechnereinheit des Kraftfahrzeuges durch die Aufnahme 8 in einen Bereich außerhalb des Drehknopfes 1 geführt werden.

Langt der Kraftfahrzeugführer mit seinem Daumen 6 und einem Finger 7 in den Bereich zwischen dem Wulst 3 und dem Steg 4, dann befinden sich diese im Wirkungsbereich der Reflexionslichtschranke 12. Die von der Leuchtdiode 14 emittierte Lichtstrahlung 13 wird an dem Daumen 6 in die Richtung des Fototransistors 15 reflektiert, der entsprechende Stromkreise der Elektronik 16 schließt bzw, öffnet, wodurch der r Lichtleiter 17 bei eingeschalteter Beleuchtung seine Lichtfarbe ändert.

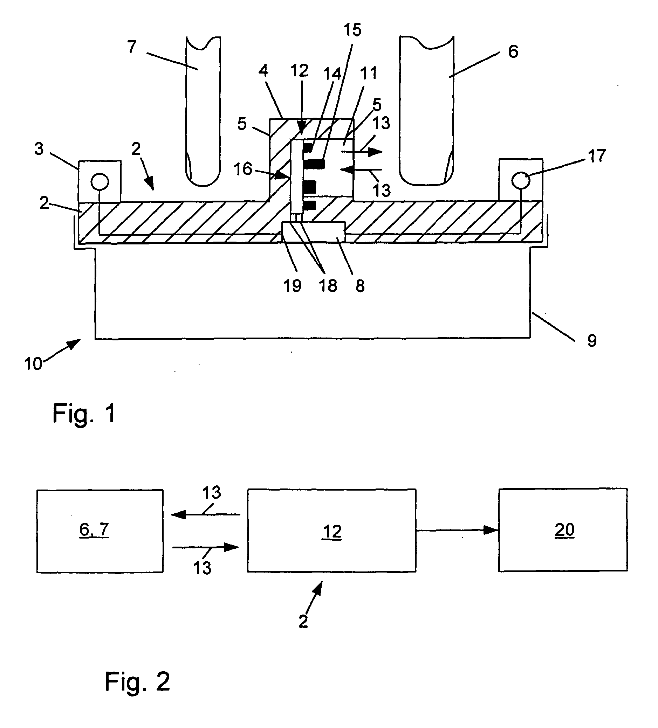

Das Blockschaltbild nach Fig. 2 veranschaulicht schematisch die Funktionsweise des Betätigungelementes 2. Die in dem Betätigungselement 2 integrierte Reflexionslichtschranke 12 sendet infrarote Lichtstrahlung 13 in die Richtung des Daumens 6 bzw. des Fingers 7 des Kraftfahrzeugführers aus. Die Lichtstrahlung wird an dem Daumen 6 bzw. Finger 7 in die Richtung der Reflexionslichtschranke 12 reflektiert und löst mindestens eine bestimmte, der Schaltfunktion des Schalters 10 vorgeordnete Schaltfunktion 20 aus.

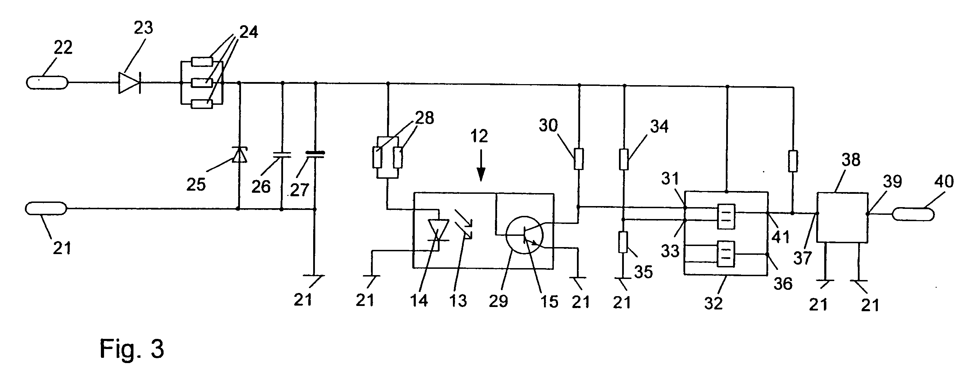

Nach dem dem Drehknopf 1 zugeordneten Schaltplan gemäß Fig. 3 dienen Kontakte 21 und 22 zum Anschluß an das Bordnetz, wobei der Kontakt 21 mit der Masse und der Kontakt 22 mit einer Spannungsquelle in Verbindung steht. In Reihe zu dem Kontakt 22 sind eine Diode 23 sowie parallel geschaltete Widerstände 24 angeordnet. Den Widerständen 24 ist eine in Sperrichtung betriebene Z-Diode 25 nachgeschaltet, zu der Kondensatoren 26, 27 parallel verlaufen. Die beschriebenen Bauteile dienen zur Spannungsversorgung der Reflexionslichtschranke 12, wobei der Kondensator 27 ein Glättkondensator ist. Im weiteren Verlauf befinden sich parallel geschalteten Widerstände 28 als Vorwiderstände für die Lichtstrahlung 13 emittierende Leuchtdiode 14.

Die Lichtstrahlung 13 gelangt durch Reflexion über einen Tageslichtfilter 29 zu dem Fototransistor 15, der zum einen mit einem Widerstand 30 und zum anderen mit einem Eingang 31 eines einfach beschalteten zweifach Komperators 32 verbunden ist. Ein weiterer Eingang 33 des Komperators 32 wird über die in Reihe geschalteten Widerstände 34, 35 mit einer Vergleichsspannung gespeist. Bei einfallender Lichtstrahlung 13 schaltet der Fototransistor 15 durch und liefert am Ausgang 36 des Komperators 32 einen relativ hohen Strom, der über einen Eingang 37 eine integrierte Schaltung 38 beaufschlagt, deren Ausgang 39 mit einem Kontakt 40 zur Ansteuerung nachfolgender Schaltfunktionen verbunden ist.

Erreicht die Lichtstrahlung 13 der Leuchtdiode 14 nicht den Fototransistor 15, dann ist ein Ausgang 41 des Komperators 32 beschaltet, und es liegt eine Versorgungsspannung an der Leuchtdiode 14 an.

## Patentansprüche

1. Mechanisches Betätigungselement für einen elektrischen Schalter (10), insbesondere Kraftfahrzeugschalter, mit einem integrierten Sensor (12) **dadurch gekennzeichnet, daß** der Sensor (12) bei der Annäherung einer Hand an das Betätigungselement (2) mindestens eine der Schaltfunktion des Schalters (10) vorgeordnete Schaltfunktion (20) auslöst, die beendet ist, bevor der eigentliche, durch die entsprechende Beaufschlagung des Betätigungselementes (2) definierte Schaltvorgang beginnt.

2. Betätigungselement nach Anspruch 1, **dadurch gekennzeichnet, daß** der Sensor (12) als Reflexionslichtschranke (12), als Fingerabdruckerkennungssensor, als Infrarotsensor oder dgl. ausgebildet ist.

3. Betätigungselement nach Anspruch 2, **dadurch gekennzeichnet, daß** die Reflexionslichtschranke (12) eine eine Lichtstrahlung (13) emittierende Leuchtdiode (14) als Sender und einen Fototransistor (15) als Empfänger umfaßt, wobei das Betätigungselement (2) mindestens in den Bereichen, in denen die Leuchtdiode (14) und der Fototransistor (15) angeordnet sind, transparent ausgebildet ist.

4. Betätigungselement nach Anspruch 3, **dadurch gekennzeichnet, daß** die emittierte Lichtstrahlung (13) ein Infrarotlicht ist.

5. Betätigungselement nach den Ansprüchen 3 und 4, **dadurch gekennzeichnet, daß** der Empfänger der Lichtstrahlung (13) von einem Tageslichtfilter (26) umgeben ist.

6. Betätigungselement nach einem der Ansprüche 1 bis 5, **dadurch gekennzeichnet, daß** eine von dem Sensor (12) angesteuerte Suchbeleuchtung in das Betätigungselement (2) integriert ist.

7. Betätigungselement nach einem der Ansprüche 1 bis 6, **dadurch gekennzeichnet, daß** eine von dem Sensor (12) geschaltete Funktionsbeleuchtung in das Betätigungselement (2) integriert ist.

8. Betätigungselement nach Anspruch 7, **dadurch gekennzeichnet, daß** sich die Lichtfarbe der Funktionsbeleuchtung in Abhängigkeit von der Schaltfunktion des Schalters in eine "Warnfarbe" ändert.

9. Betätigungselement nach einem der Ansprüche 6 bis 8, **dadurch gekennzeichnet, daß** die Suchbeleuchtung bzw. die Funktionsbeleuchtung mindestens eine Leuchtdiode, einen Lichtleiter (17) oder dgl. umfaßt.

10. Betätigungselement nach einem der Ansprüche 1 bis 5, **dadurch gekennzeichnet, daß** der Sensor (12) mit einer zentralen, komplexe Schaltfunktionen aufbereitenden Rechnereinheit des Kraftfahrzeuges gekoppelt ist.

11. Betätigungselement nach einem der Ansprüche 2 bis 10, **dadurch gekennzeichnet, daß** nach einer Beaufschlagung des in das Betätigungselement (2) integrierten Fingerabdruckerkennungssensors durch einen berechtigten Kraftfahrzeugführer die elektronische Wegfahrsperre durch die dem Fingerabdruckerkennungssensor zugeordnete Schaltfunktion (20) deaktiviert ist.

12. Betätigungselement nach einem der Ansprüche 2 bis 11, **dadurch gekennzeichnet, daß** nach einer Beaufschlagung des in das Betätigungselement (2) integrierten Fingerabdruckerkennungssensors durch einen berechtigten Kraftfahrzeugführer die verriegelte Lenksäule über die dem Fingerabdruckerkennungssensor zugeordnete Schaltfunktion (20) entriegelt ist.

## Claims

1. Mechanical actuating element for an electric switch (10), in particular a motor vehicle switch, having an integrated sensor (12), **characterised in that** the sensor (12) on the approach of a hand to the actuating element (2) triggers at least one switching function (20) arranged ahead of the switching function of the switch (10) that is terminated before the actual switching operation defined by the corresponding action on the actuating element (2).

2. Actuating element according to claim 1, **characterised in that** the sensor (12) is constructed as a reflected light barrier (12), as a fingerprint recognition sensor, as an infrared sensor or the like.

3. Actuating element according to claim 2, **characterised in that** the reflected light barrier (12) comprises a light-emitting diode (14) as transmitter emitting light radiation (13) and a phototransistor (15) as receiver, wherein the actuating element (2) is of transparent construction at least in the regions in which the light-emitting diode (14) and the phototransistor (15) are arranged.

4. Actuating element according to claim 3, **characterised in that** the emitted light radiation (13) is infrared light.

5. Actuating element according to claims 3 and 4, **characterised in that** the receiver of the light radiation (13) is surrounded by a daylight filter (26).

6. Actuating element according to any of claims 1 to 5, **characterised in that** search lighting controlled by the sensor (12) is integrated into the actuating element (2).

7. Actuating element according to any of claims 1 to 6, **characterised in that** functional lighting switched by the sensor (12) is integrated into the actuating element (2).

8. Actuating element according to claim 7, **characterised in that** the light colour of the functional lighting changes into a "warning colour" as a function of the switching function of the switch.

9. Actuating element according to any of claims 6 to 8, **characterised in that** the search lighting or the functional lighting comprises at least one light-emitting diode, an optical waveguide (17) or the like.

10. Actuating element according to any of claims 1 to 5, **characterised in that** the sensor (12) is linked to a central computer unit of the motor vehicle providing complex switching functions.

11. Actuating element according to any of claims 2 to 10, **characterised in that** after the fingerprint recognition sensor integrated into the actuating element (2) has been acted upon by an authorised motor vehicle driver the electronic immobiliser is deactivated by the switching function (20) associated with fingerprint recognition sensor.

12. Actuating element according to any of claims 2 to 11, **characterised in that** after the fingerprint recognition sensor integrated into the actuating element (2) has been acted upon by an authorised motor vehicle driver the locked steering column is unlocked via the switching function (20) associated with the fingerprint recognition sensor.

## Revendications

1. Élément d'actionnement mécanique pour un commutateur électrique (10) en particulier un commutateur de véhicule, avec un capteur intégré (12) **caractérisé en ce que** lors de l'approche d'une main près de l'élément d'actionnement (2), le capteur (12) déclenche au moins une fonction de commutation préréglée de la fonction de commutation (20) du commutateur (10), qui se termine avant que ne commence l'opération de commutation proprement dite définie par la sollicitation correspondante de l'élément d'actionnement (2).

2. Élément d'actionnement selon la revendication 1, **caractérisé en ce que** le capteur (12) est configuré comme une barrière lumineuse à réflexion (12), comme un détecteur de reconnaissance d'empreinte digitale, comme un capteur à infrarouge ou similaire.

3. Élément d'actionnement selon la revendication 2, **caractérisé en ce que** la barrière lumineuse à réflexion (12) comprend une diode électroluminescente (14) émettant un rayonnement lumineux (13) comme émetteur et un phototransistor (15) comme récepteur, l'élément d'actionnement (2) étant transparent au moins dans les zones dans lesquelles sont disposés la diode électroluminescente (14) et le phototransistor (15).

4. Élément d'actionnement selon la revendication 3, **caractérisé en ce que** le rayonnement lumineux émis (13) est une lumière infrarouge.

5. Élément d'actionnement selon les revendications 3 et 4, **caractérisé en ce que** le récepteur du rayonnement lumineux (13) est entouré d'un filtre de lumière du jour (26).

6. Élément d'actionnement selon l'une des revendications 1 à 5, **caractérisé en ce qu'**un éclairage de détection commandé à partir du capteur (12) est intégré dans l'élément d'actionnement (2).

7. Élément d'actionnement selon l'une des revendications 1 à 6, **caractérisé en ce qu'**un éclairage fonctionnel commuté par le capteur (12) est intégré dans l'élément d'actionnement (2).

8. Élément d'actionnement selon la revendication 7, **caractérisé en ce que** la couleur de la lumière de l'éclairage fonctionnel se modifie en dépendance de la fonction commutation du commutateur en une "couleur signalétique".

9. Élément d'actionnement selon l'une des revendications 6 à 8, **caractérisé en ce que** l'éclairage de détection ou l'éclairage fonctionnel comprend au moins une diode électroluminescente, un conducteur optique (17) ou similaire.

10. Élément d'actionnement selon l'une des revendications 1 à 5, **caractérisé en ce que** le capteur (12) est couplé à un processeur central du véhicule éditant des fonctions de commutation complexes.

11. Élément d'actionnement selon l'une des revendications 2 à 10, **caractérisé en ce qu'**après une sollicitation du détecteur de reconnaissance d'empreinte digitale intégré à l'élément d'actionnement (2) par un conducteur de véhicule autorisé, le verrouillage électronique de démarrage est désactivé par la fonction de commutation associée au détecteur de reconnaissance d'empreinte digitale.

12. Élément d'actionnement selon l'une des revendications 2 à 11, **caractérisé en ce qu'**après une sollicitation du détecteur de reconnaissance d'empreinte digitale intégré à l'élément d'actionnement (2) par un conducteur de véhicule autorisé, la colonne de direction verrouillée est déverrouillée par la fonction de commutation associée au détecteur de reconnaissance d'empreinte digitale.
